# EUROPEAN PATENT SPECIFICATION

(11) **EP 0 427 285 B1**
(45) Date of publication and mention of the grant of the patent: **23.04.1997**
(21) Application number: 90121469.2
(22) Date of filing: 09.11.1990
(51) Int. Cl.: H01L 21/311, H01L 21/76, H01L 21/28

(54) **Method of manufacturing radiation resistant semiconductor device**
Verfahren zur Herstellung mit hoher Strahlungsbeständigkeit
Procédé pour la fabrication d'un dispositif semi-conducteur à haute dureté de rayonnement

(30) Priority: 10.11.1989 JP 293495/89
(43) Date of publication of application: 15.05.1991
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Hama, Kaoru, c/o Intellectual Property Division, Minato-ku, Tokyo 105 (JP)
(74) Representative: Lehn, Werner, Dipl.-Ing.

(56) References cited:
- PATENT ABSTRACTS OF JAPAN, unexamined applications, section E, vol. 11, no. 275, September 05, 1987 THE PATENT OFFICE JAPANESE GOVERNMENT page 151 E 537; & JP-A-63 076 559
- PATENT ABSTRACTS OF JAPAN, unexamined applications, section E, vol. 12, no. 322, August 31, 1988 THE PATENT OFFICE JAPANESE GOVERNMENT page 14 E 652; & JP-A-63 086 514
- PATENT ABSTRACTS OF JAPAN, unexamined applications, section E, vol. 5, no. 3, January 10, 1981 THE PATENT OFFICE JAPANESE GOVERNMENT page 55 E 40; & JP-A-55 133 556

## Description

The present invention relates to a method of manufacturing a radiation resistant semiconductor device used in, e.g., a space satellite, or a nuclear power plant.

It is known that when an ionizing radiation such as an x-ray, a γ-ray, or a high-energy charged particle is radiated onto a semiconductor device, a large amount of electron-hole pairs are created in an oxide film. (C. L. Emms et al., "Gamma and Vacuum Irradiations of Ion Implanted SiO₂ for MOS Dielectrics", IEEE Transactions on Nuclear Science, Vol. NS-21, pages 159 to 166, December 1974). It is well known that a drift velocity of electrons in an oxide film is higher than that of holes. For this reason, the electrons of the electron-hole pairs generated in an oxide film disappear faster than the holes, and the many holes are left, and some portion of these holes are trapped in the oxide film. Therefore a p-type substrate under the oxide film can be inverted into a n-type one due to these trapped holes. As a consequence, when the positive charges (holes) are trapped in a field oxide film, a leakage current between circuit elements is increased. When the positive charges are trapped in a gate oxide film, a threshold voltage of the transistor is changed. Moreover, in a small-geometry LDD transistor, when many positive charges are trapped in the oxide film formed on side walls of a gate electrode, a strong accumulation of electrons otherwise in a low-electron concentration n⁻-type region occurs. Therefore, the transistor cannot be operated as an LDD transistor.

As conventional techniques for overcoming the above problem, a guard-band structure (H. Hietano et al., "A Radiation-Hardened 10K-Gate CMOS Gate Array", IEEE Transactions on Nuclear Science, Vol. 36, No. 6, pages 2435 to 2438, December 1989) is employed to the field oxide film, the field oxide film is formed at a low temperature, or the field oxide film is made of two layers. In addition, it is known that a decrease in thickness and a treatment at a low temperature are effective to hardening of an oxide film.

However, in a semiconductor device having the guard-band structure, since the circuit elements must be arranged in consideration of radiation resistance in a mask design, the design becomes difficult. When the field oxide film is formed at a low temperature, a long time is required for growing the oxide film. Therefore, this method is not practical in the manufacture. In addition, when the oxide film is formed to have two layers, an interface between the two layers disadvantageously disappears by annealing after formation of the oxide film.

As for the oxide film on the side wall of the gate electrode of the LDD transistor, a technique for enhancing radiation resistance has never been developed.

The present invention is made in consideration of the above drawbacks, and has as its object to provide a method of manufacturing a radiation resistant semiconductor device, capable of manufacturing semiconductor devices having good radiation resistance.

This object is solved by the method of claim 1.

According to an aspect of the present invention, there is provided a method of manufacturing a radiation resistant semiconductor device, comprising the steps of forming an oxide film on a semiconductor substrate, depositing a metallic boron film on the oxide film, and diffusing boron from the metallic boron film to the oxide film by annealing.

According to another aspect of the present invention, there is provided a method of manufacturing a radiation resistant semiconductor device, comprising the steps of forming an element isolation oxide film and a gate insulating oxide film on a semiconductor substrate, depositing a metallic boron film on the element isolation oxide film and the gate insulating oxide film, and diffusing boron from the metallic boron film to the element isolation oxide film and the gate insulating oxide film by annealing.

According to still another aspect of the present invention, there is provided a method of manufacturing a radiation resistant semiconductor device, comprising the steps of depositing a silicon nitride film on a semiconductor substrate, patterning the silicon nitride film to leave the silicon nitride film in a region where an element isolation oxide film is not formed, forming the element isolation oxide film by oxidization, depositing a metallic boron film on the entire surface of the silicon substrate; and diffusing metallic boron from the metallic boron film to the element isolation oxide film by annealing.

According to still another aspect of the present invention, there is provided a method of manufacturing a radiation resistant semiconductor device, comprising the steps of forming a gate electrode on a semiconductor substrate, depositing an oxide film on the gate electrode, depositing a metallic boron film on the oxide film, diffusing boron from the metallic boron film to the oxide film by annealing, and leaving the oxide film on only the side walls of the gate electrode with an anisotropical etching method.

According to still another aspect of the present invention, there is provided a method of manufacturing a radiation resistant semiconductor device, comprising the steps of forming an oxide film on a semiconductor substrate, depositing a film containing at least one element selected from a group consisting of boron, phosphorus, and arsenic on the oxide film, and diffusing at least one selected from the group consisting of boron, phosphorus, and arsenic from the film to the oxide film by annealing.

This invention can be more fully understood from the following detailed description when taken in conjunction with the accompanying drawings, in which:
Figs. 1A to 1F are sectional views showing the steps in a first method of manufacturing a radiation resistant semiconductor device according to the present invention;
Figs. 2A to 2C are sectional views showing the steps in a second method of manufacturing a radiation resistant semiconductor device according to the present invention; and
Figs. 3A to 3D are sectional views showing the steps in a third method of manufacturing a radiation resistant semiconductor device according to the present invention.

Methods of manufacturing a radiation resistant semiconductor device according to the present invention will be described with reference to the accompanying drawings.

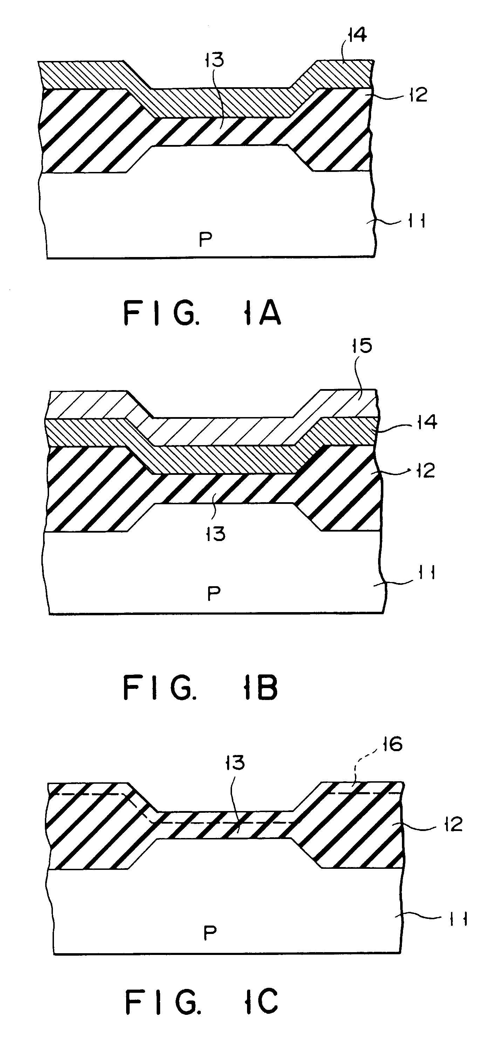

Figs. 1A to 1F are sectional views showing the steps of a first manufacturing method when the present invention is employed to manufacture a MOS transistor.

As shown in Fig. 1A, a field oxide film 12 and a gate oxide film 13 are formed on a p-type silicon semiconductor substrate 11 by a selective oxidation method, and a polysilicon film 14 is formed thereon by a CVD method (chemical vapor deposition method) or the like.

As shown in Fig. 1B, a metallic boron film 15 is deposited on the polysilicon film 14 by a vacuum deposition method to have a thickness of about 0.1 µm.

Thereafter, as shown in Fig. 1C, the resultant structure is annealed at a temperature of 900°C or more in a non-oxidizing atmosphere to diffuse the boron (B) from the metallic boron film 15 to both the field oxide film 12 and the gate oxide film 13 using the polysilicon film 14 as a buffer member, so as to form a boron doped region 16 on the surface of both the field oxide film 12 and the gate oxide film 13. If the metallic boron atoms are doped by an implantation, the oxide films may be seriously damaged by the implanted ions. For this reason, an amount of trapped charges may be more significantly increased than those without implantations. Therefore, according to the present invention, the metallic boron atoms are diffused by annealing. Thereafter, the metallic boron film 15 is removed, and the polysilicon film 14 thereunder is removed to expose the surfaces of the field oxide film 12 and the gate oxide film 13.

As shown in Fig. 1D, a polysilicon film 17 is deposited on the surface of the field oxide film 12 and the gate oxide film 13, and phosphorus is doped in the polysilicon film 17. The phosphorus may have a concentration at which the electric resistance of the gate electrode is satisfactorily low.

As shown in Fig. 1E, the phosphorus doped in the polysilicon film 17 is further diffused by annealing. At this time, the boron atoms are diffused from the boron doped region 16 of the field oxide film 12 and the gate oxide film 13. When the boron atoms are diffused near the interface between the gate oxide film 13 and the substrate 11, the diffusion step is stopped. In this embodiment, a time required for the diffusion step is determined in consideration of the thickness of the gate oxide film 13.

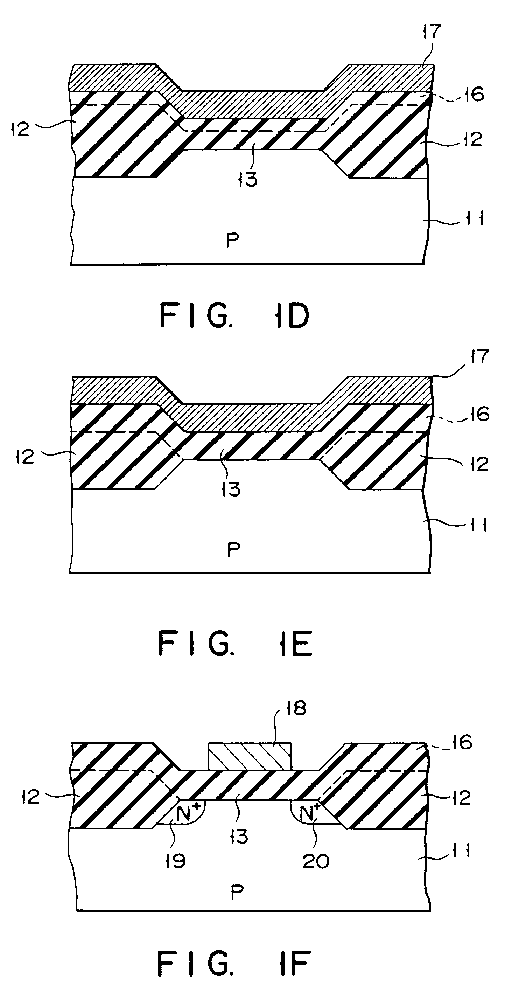

As shown in Fig. 1F, the polysilicon film 17 is patterned using a predetermined mask by a selective etching method to form a gate electrode 18. Thereafter, an n-type impurity such as arsenic (As) is implanted in the surface of the substrate 11 and is activated to form a pair of n-type regions 19 and 20 serving as source and drain regions.

In the MOS transistor manufactured by the above first manufacturing method of the present invention, the boron atoms are doped in both the field oxide film 12 and the gate oxide film 13. Electrons generated by radiation exposure are caught once by traps formed by the boron atoms, and then the electrons are recombined with the holes at a high probability. As a result, the number of the holes available for trapping in the field oxide film 12 and the gate oxide film 13 is largely decreased compared with the conventional techniques.

According to the first manufacturing method of the present invention, since a guard-band structure need not be employed, a semiconductor device can be easily designed. In addition, since the field oxide film can be formed at a relatively high temperature, a conventional manufacturing process can be easily applied to easily manufacturing a radiation resistant semiconductor device.

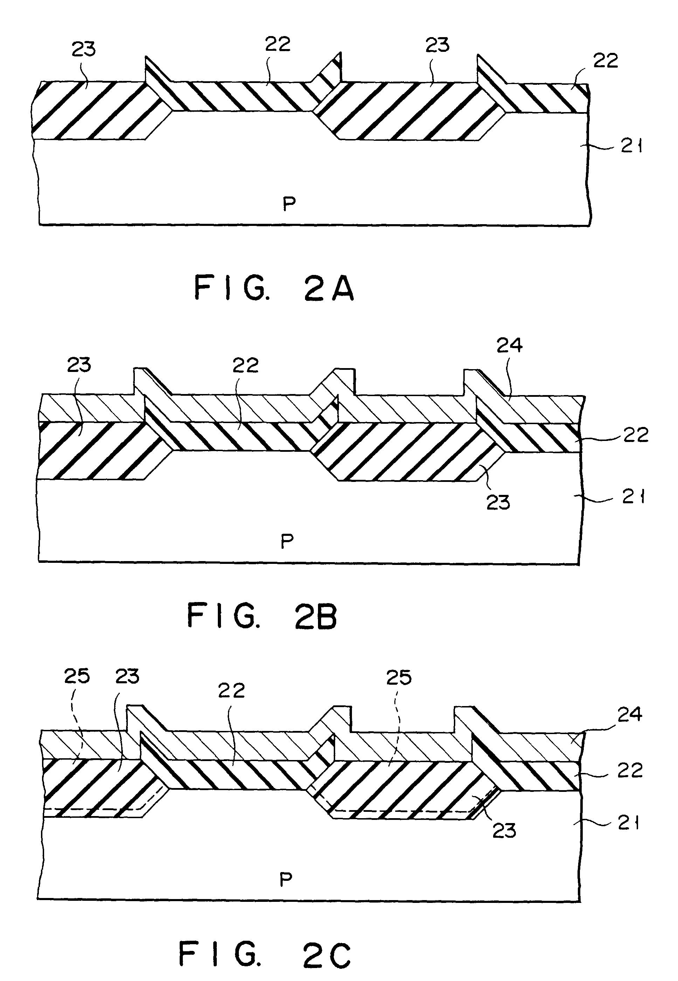

Figs. 2A to 2C are sectional views showing the steps of a second manufacturing method of the present invention when the present invention is applied to the manufacturing of a MOS transistor with boron doped only in field oxide.

As shown in Fig. 2A, a selective oxidation mask member such as a silicon nitride film 22 having a predetermined pattern is formed on a p-type silicon semiconductor substrate 21. A field oxide film 23 is formed on the substrate 21 by a thermal oxidation method using the silicon nitride film 22 as a mask.

As shown in Fig. 2B, with the silicon nitride film 22 left unremoved, a metallic boron film 24 is deposited on an entire surface of the resultant structure by a vacuum deposition method or the like to have a thickness of about 0.1 µm.

As shown in Fig. 2C, the resultant structure is annealed in a non-oxidizing atmosphere at a temperature of 900°C or more to diffuse the boron from the metallic boron film 24 to the field oxide film 23 so as to form a boron doped region 25. In this embodiment, the time required for the diffusion step is determined in consideration of the thickness of the field oxide film 23. Since the silicon nitride film 22 is left on the surface of the substrate 21 where the field oxide film 23 is not formed, the boron atoms are not diffused in the substrate 21.

Thereafter, the metallic boron film 24 and the silicon nitride film 22 are removed to expose the surfaces of the field oxide film 23 and the substrate 21. Therefore, a gate oxide film is formed, and a gate electrode and a pair of n⁺-type regions (neither are shown) serving as source and drain regions are formed.

According to the second manufacturing method of the present invention, since the boron atoms are doped in the field oxide film 23 by diffusion step before the gate oxide film is formed, the boron can be diffused in the field oxide film to a sufficiently deep depth without considering the thickness of the gate oxide film which is generally thinner than the field oxide film. Therefore, the holes trapped in the field oxide film 23 can be extremely reduced.

Note that, in the second manufacturing method of the present invention, after the gate oxide film is formed, the boron may be doped in the gate oxide film in another step.

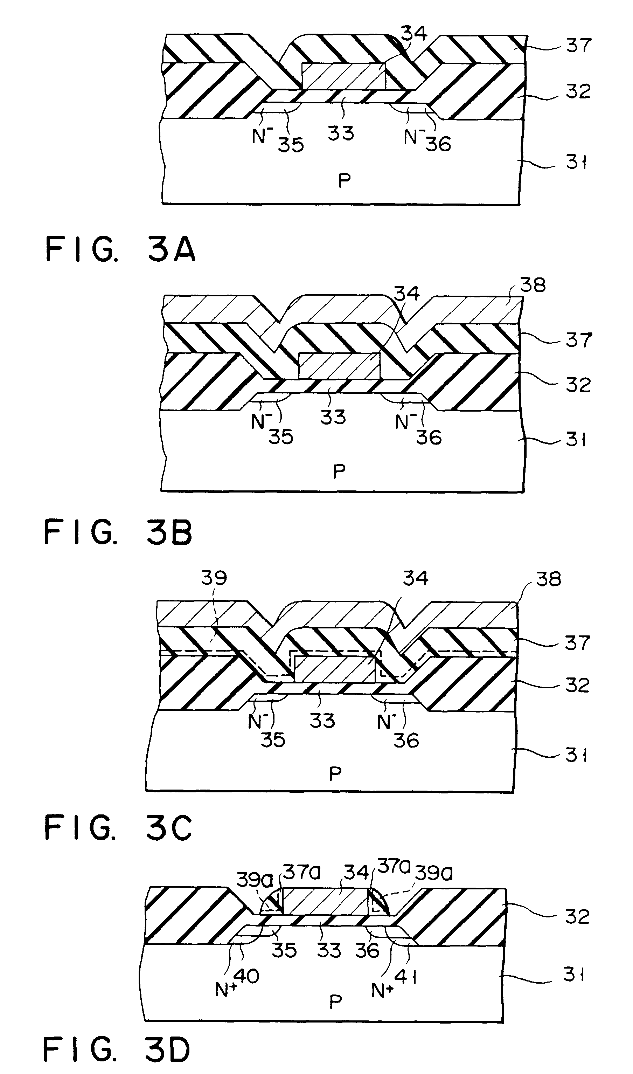

Figs. 3A to 3D are sectional views showing a third manufacturing method of the present invention when the present invention is applied to the manufacturing of a small-geometry LDD transistor.

As shown in Fig. 3A, a field oxide film 32 and a gate oxide film 33 are formed on a p-type silicon semiconductor substrate 31 by a thermal oxidation method. A gate electrode 34 made of a polysilicon film is formed on the gate oxide film 33. Thereafter, a pair of n⁻-type regions 35 and 36 are formed on the surface of the substrate 31 by an ion-implantation method using the field oxide film 32 and the gate electrode 34 as masks. An oxide film 37 is deposited on an entire surface of the resultant structure by a CVD method.

As shown in Fig. 3B, a metallic boron film 38 is deposited on the oxide film 37 by a vacuum deposition method or the like to have a thickness of about 0.1 µm.

As shown in Fig. 3C, the resultant structure is annealed in a non-oxidizing atmosphere at a temperature of 900°C or more to diffuse the boron from the metallic boron film 38 to the oxide film 37 so as to form a boron doped region 39.

As shown in Fig. 3D, after the metallic boron film 38 is removed, the oxide film 37 is etched by an anisotropic etching method such as a reactive ion etching (RIE) method to leave the oxide film 37 on only each side wall 37a of the gate electrode 34. Thereafter, a pair of n⁺-type regions 40 and 41 are formed on the surface of the substrate 31 by the ion-implantation method using the field oxide film 32, the gate electrode 34, and the side wall 37a as masks.

As described above, according to the third manufacturing method of the present invention, the boron can be doped in the silicon oxide film 37 formed on the side walls 37a of the gate electrode 34 so that the radiation resistance of the side wall oxides are improved.

The present invention is not limited to the above embodiments, and various modifications can be effected. For example, in each embodiment described above, although the metallic boron film is deposited on the oxide film in which the boron should be doped, "a film containing boron" such as a borosilicate glass (BSG) film can be deposited. In each embodiment described above, although a case wherein the boron atoms are doped from the metallic boron film to the oxide film and then the metallic boron film is removed is described, the film containing boron may be left unremoved if such film is very thin. In the above embodiments, the metallic boron film or the "film containing metallic boron" has been used. However, when a film containing at least one element selected from a group consisting of phosphorus and arsenic, a film containing two elements selected from the group consisting of metallic boron, phosphorus and arsenic, or a film containing metallic boron, phosphorus, and arsenic may be used in place of the "film containing boron", the same effect as described above can be obtained.

Reference signs in the claims are intended for better understanding and shall not limit the scope.

## Claims

1. A method for manufacturing a radiation resistant semiconductor device, comprising the steps of:
forming an oxide film (12, 13; 23; 32, 33) on a semiconductor substrate (11; 21; 31);
depositing a film (15; 24; 38) containing at least one element selected from a group consisting of metallic boron, phosphorous, and arsenic to said oxide film (12, 13; 23; 32, 33);
diffusing atoms of said at least one element selected from the group consisting of metallic boron, phosphorous, and arsenic from said film (15; 24; 38) to said oxide film (12, 13; 23; 32, 33) by annealing; and
stopping said step of diffusing near the interface between said oxide film (12, 13; 23; 32, 33) and said semiconductor substrate (11; 21; 31).

2. The method according to claim 1, wherein said oxide film comprises an element isolation oxide film (12) and a gate insulation film (13).

3. The method according to claim 1,
wherein said step of forming an oxide film (23) on a semiconductor substrate (21) comprises the steps of:
depositing a silicon nitride film (22) on said semiconductor substrate (21);
patterning said silicon nitride film (22) to leave said silicon nitride film (22) in a region where an element isolation oxide film (23) is not to be formed; and
forming said element isolation oxide film (23) by oxidation, and
wherein said film (24) is deposited on a surface of said element isolation oxide film (23).

4. The method according claim 1,
wherein said step of forming an oxide film (37) on a semiconductor substrate (31) comprises the steps of:
forming a gate electrode (34) on said semiconductor substrate (31); and
depositing an oxide film (37) on said gate electrode (34);
wherein said film (38) is deposited on said oxide film (37); and
wherein said method further comprises the step of
leaving said oxide film (37) on only side walls (37a) of said gate electrode (34).

## Patentansprüche

1. Verfahren zum Herstellen einer strahlungsfesten Halbleitervorrichtung, das folgende Schritte aufweist:
Bilden eines Oxidfilms (12, 13; 23; 32, 33) auf einem Halbleitersubstrat (11; 21; 31);
Ablagern eines Films (15; 24; 38), der wenigstens ein Element enthält, das aus einer Gruppe ausgewählt ist, die aus metallischem Bor, Phosphor und Arsen besteht, zum Oxidfilm (12, 13; 23; 32, 33);
Diffundieren von Atomen des wenigstens einen Elements, das aus der Gruppe ausgewählt ist, die aus metallischem Bor, Phosphor und Arsen besteht, von dem Film (15; 24; 38) zu dem Oxidfilm (12, 13; 23; 32, 33) durch Ausglühen; und
Anhalten des Schritts zum Diffundieren nahe der Schnittstelle zwischen dem Oxidfilm (12, 13; 23; 32, 33) und dem Halbleitersubstrat (11; 21; 31).

2. Verfahren nach Anspruch 1, wobei der Oxidfilm einen Elementenisolations-Oxidfilm (12) und einen Gate-Isolierfilm (13) aufweist.

3. Verfahren nach Anspruch 1,
wobei der Schritt zum Bilden eines Oxidfilms (23) auf einem Halbleitersubstrat (21) folgende Schritte aufweist:
Abscheiden eines Siliziumnitridfilms (22) auf dem Halbleitersubstrat (21);
Mustern des Siliziumnitridfilms (22), um den Siliziumnitridfilm (22) in einem Bereich zurückzulassen, wo ein Elementenisolations-Oxidfilm (23) nicht auszubilden ist; und
Ausbilden des Elementenisolations-Oxidfilms (23) durch Oxidation, und
wobei der Film (24) auf einer Oberfläche des Elementenisolations-Oxidfilms (23) abgeschieden wird.

4. Verfahren nach Anspruch 1,
wobei der Schritt zum Ausbilden eines Oxidfilms (37) auf einem Halbleitersubstrat (31) folgende Schritte aufweist:
Bilden einer Gate-Elektrode (34) auf dem Halbleitersubstrat (31) ; und
Abscheiden eines Oxidfilms (37) auf der Gate-Elektrode (34);
wobei der Film (38) auf dem Oxidfilm (37) abgelagert wird; und
wobei das Verfahren weiterhin folgenden Schritt aufweist:
Zurücklassen des Oxidfilms (37) nur an den Seitenwänden (37a) der Gate-Elektrode (34).

## Revendications

1. Procédé de fabrication d'un dispositif à semiconducteur résistant aux radiations, qui comprend les opérations suivantes :
former une pellicule d'oxyde (12, 13 ; 23 ; 32, 33) sur un substrat semiconducteur (11; 21; 31);
déposer une pellicule (15 ; 24 ; 38) contenant au moins un élément choisi dans un groupe constitué du bore métallique, du phosphore et de l'arsenic, sur ladite pellicule d'oxyde (12, 13 ; 23 ; 32, 33);
faire diffuser des atomes dudit ou desdits éléments choisis dans le groupe constitué du bore métallique, du phosphore et de l'arsenic, de ladite pellicule (15 ; 24 ; 38) jusque dans ladite pellicule d'oxyde (12, 13 ; 23 ; 32, 33) par recuit ; et
arrêter l'opération de diffusion au voisinage de l'interface entre ladite pellicule d'oxyde (12, 13 ; 23 ; 32, 33) et ledit substrat semiconducteur (11 ; 21 ; 31).

2. Procédé selon la revendication 1, où ladite pellicule d'oxyde comprend une pellicule d'oxyde d'isolation d'éléments (12) et une pellicule d'isolation de grille (13).

3. Procédé selon la revendication 1, où ladite opération de formation d'une pellicule d'oxyde (23) sur un substrat semiconducteur (21) comprend les opérations suivantes:
déposer une pellicule de nitrure de silicium (22) sur ledit substrat semiconducteur (21) ;
appliquer un tracé de motif à ladite pellicule de nitrure de silicium (22) afin de laisser ladite pellicule de nitrure de silicium (22) dans une région où une pellicule d'oxyde d'isolation d'éléments (23) ne doit pas être formée ; et
former ladite pellicule d'oxyde d'isolation d'éléments (23) par oxydation, et
où ladite pellicule (24) est déposée sur une surface de ladite pellicule d'oxyde d'isolation d'éléments (23).

4. Procédé selon la revendication 1, où ladite opération de formation d'une pellicule d'oxyde (37) sur un substrat semiconducteur (31) comprend les opérations suivantes :
former une électrode de grille (34) sur ledit substrat semiconducteur (31) ; et
déposer une pellicule d'oxyde (37) sur ladite électrode de grille (34) ;
où ladite pellicule (38) est déposée sur ladite pellicule d'oxyde (37) ; et
où ledit procédé comprend en outre l'opération consistant à ne laisser ladite pellicule d'oxyde (37) que sur les parois latérales (37a) de ladite électrode de grille (34).
